Europäisches Patentamt

European Patent Office

Office européen des brevets

(19)

(11) Veröffentlichungsnummer: **0 037 005**
**B1**

(12) EUROPÄISCHE PATENTSCHRIFT

(45) Veröffentlichungstag der Patentschrift:
13.02.85

(51) Int. Cl.⁴: **H 01 L 23/54, H 05 B 33/26**

(21) Anmeldenummer: **81101984.3**

(22) Anmeldetag: **17.03.81**

(54) Sperrfreier niederohmiger Kontakt auf III-V-Halbleitermaterial und Verfahren zu seiner Herstellung.

(30) Priorität: **27.03.80 DE 3011952**

(43) Veröffentlichungstag der Anmeldung:
**07.10.81 Patentblatt 81/40**

(45) Bekanntmachung des Hinweises auf die Patenterteilung:
**13.02.85 Patentblatt 85/7**

(84) Benannte Vertragsstaaten:
**AT FR GB IT NL SE**

(56) Entgegenhaltungen:
**CH - A - 478 457
DE - A - 2 732 808
DE - B - 1 280 420
GB - A - 876 807
GB - A - 1 199 815
US - A - 3 483 096**

**IEEE TRANSACTIONS ON ELECTRON DEVICES, Vol. ED-26, No. 8, August 1979 KENICH IGA et al. "Galn AsP/InP Double-Heterostructure Planar LED's"
Physica Status Solidi (a)50, K 219, (1978)**

(73) Patentinhaber: **Siemens Aktiengesellschaft, Berlin und München Wittelsbacherplatz 2, D-8000 München 2 (DE)**

(72) Erfinder: **Lauterbach, Christl geb. Engelbrecht, Defreggerstrasse 1, D-8012 Ottobrunn (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung bezieht sich auf einen sperrfreien niederohmigen Kontakt, wie er im Oberbegriff des Patentanspruchs 1 angegeben ist, und auf eine Verfahrensmaßnahme zu dessen Herstellung.

Für p-leitende Indium-haltige III-V-Halbleiter, wie z. B. Indium-Gallium-Arsenid, -Phosphid oder Indium-Gallium-Arsenidphosphid, werden elektrische Kontakte benötigt, deren Realisierung derzeit noch auf erhebliche Schwierigkeiten stößt. Es werden reproduzierbare Kontakte mit geringem spezifischen Kontaktwiderstand zwischen $10^{-4}$ und $10^{-5}$ Ohm $\cdot$ cm$^2$ gefordert und die Strom-Spannungs-Kennlinie dieser Kontakte sollte in einem weiteren Spannungsbereich ohmsches Verhalten zeigen.

Aus Phys. Stat. Sol. (a) 50, K 219 (1978) sind ohmsche Kontakte für p-leitendes Indium-haltiges III-V-Halbleitermaterial bekannt. Diese Kontakte sind durch Aufdampfen von verschiedenen Metallfolien hergestellt worden, so z. B. Kontakte aus einer Schichtstruktur aus im Grunde genommen drei Schichten, von denen die erste Schicht auf dem Halbleitermaterial eine dünne, haftende Schicht aus Indium, die zweite Schicht eine Kontaktlegierungsstoffschicht aus Zink ist und die dritte Schicht aus Silber und Gold besteht, wobei diese Schicht aus einem relativ dikken Anteil Silber und einem darauf befindlichen Schichtanteil aus Gold besteht, das einen qualitativ besseren Kontakt als das Silber gewährleistet. Kontakte aus solchen Schichten sind dadurch hergestellt worden, daß ein Einlegierungsprozeß in neutraler oder reduzierender Atmosphäre durchgeführt worden ist. Die Qualität solcher Kontakte hängt vor allem bei niedrig dotiertem Halbleitermaterial stark von der Vorbehandlung der Halbleiteroberfläche ab und ist selbst bei im Rahmen der praktischen Möglichkeiten gleicher Oberflächenbehandlung kaum reproduzierbar. Bei den verschiedenen Kontaktsystemen treten immer wieder die gleichen Probleme auf, nämlich daß zunächst für einen sperrfreien niederohmigen Kontakt zu lange einlegiert werden muß, was starke Randstörungen am Kontakt zur Folge hat. Ein derartiger Kontakt ist insbesondere für die Fälle, in denen der Stromzufluß in das Halbleitermaterial homogen sein soll, z. B. wie bei Lumineszenzdioden mit hoher Strahldichte, nicht brauchbar. Es kann zwar die Einlegierungszeit bei Erhöhung der Einlegierungstemperatur verkürzt werden. Dann dringt jedoch die Legierungsfront zu tief in das Halbleitermaterial ein, war vor allem bei dünnen Epitaxie-Schichten als Halbleitermaterial Probleme aufwirft. Insbesondere bei mehrschichtigem Epitaxie-Aufbau führt dies zu Kurzschlüssen mit den tieferliegenden Epitaxie-Schichten dieses Aufbaues. Weiterhin hat es sich als schwierig erwiesen, in einfacher Weise bondbare Kontakte auf dem bekannten Wege herzustellen, weil das Kontaktmaterial, z. B. Gold, nach dem Einlegierungsprozeß an seiner Oberfläche Beimischungen von Bestandteilen des Halbleitermaterials und der gegebenenfalls weiteren Materialien der Kontakt-Schichtfolge aufweist.

Es ist eine Aufgabe der vorliegenden Erfindung, einen solchen sperrfreien niederohmigen Kontakt für p-leitendes Indium-haltiges III-V-Halbleitermaterial und eine vorteilhafte Verfahrensmaßnahme für dessen Herstellung anzugeben, bei dem die voranstehend erwähnten Probleme vermieden sind.

Diese Aufgabe wird mit einem Kontakt nach dem Oberbegriff des Patentanspruchs 1 erfindungsgemäß durch die Merkmale des Kennzeichens des Patentanspruchs 1 gelöst. Weitere Ausgestaltungen und Weiterbildungen der Erfindung gehen aus den Unteransprüchen hervor.

Bei der vorliegenden Erfindung ist als erste Schicht auf dem Indium-haltigen Halbleitermaterial Indium verwendet worden. Indium hat dort die Wirkung, das Material des Halbleiters auszulösen und auf der Halbleiteroberfläche befindliche Oxid- und/oder Hydroxidschichten aufzubrechen. Das Indium als erste Schicht auf dem Halbleitermaterial vermittelt eine gute Haftung des Kontaktes und garantiert die gleichmäßige Eindiffusion des dotierenden Materials der im folgenden zu beschreibenden zweiten Schicht.

Die zweite Schicht besteht aus einem p-dotierenden Stoff, wie z. B. Zink, Beryllium oder Kadmium. Mit diesen Materialien läßt sich im Halbleiter im Bereich des vorgesehenen Kontaktes durch den vorzunehmenden Einlegierungsprozeß eine dünne hochdotierte Übergangsschicht erzeugen, die zu sperrfreiem und niederohmigem Kontakt führt.

Die dritte Schicht aus wie erfindungsgemäß vorgesehenem Platin, Palladium oder vor allem aus einer Chrom-Nickel-Legierung oder aus Chrom gewährleistet, daß während des durchzuführenden Einlegierungsprozesses kein Material der äußeren Kontaktschicht, wie z. B. Gold, in das Halbleitermaterial gelangt und auch kein Halbleitermaterial in die Goldschicht kommen kann. Ohne diese dritte erfindungsgemäß ausgewählte Schicht würden selbst bei relativ kurzen Einlegierungszeiten und niedrigen Einlegierungstemperaturen die Kontaktmaterialien in erheblichem Maße miteinander legieren und tief in das Halbleitermaterial eindringen.

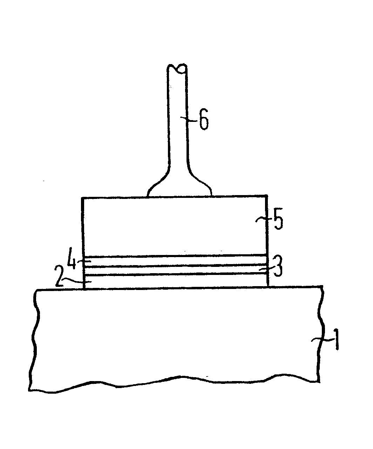

Nachfolgend wird anhand der Figur ein Ausführungsbeispiel für einen erfindungsgemäßen Kontakt aus einem p-leitenden III-V-Halbleitermaterial wie Indiumphosphid oder Indium-Gallium-Arsenidphosphid beschrieben, mit einer p-Dotierung von $10^{18}$ Teilchen $\cdot$ cm$^{-3}$. Auf dem p-leitenden Halbleitermaterial 1, das z. B. eine 1 bis 2 µm dicke Epitaxie-Schicht ist, wird zunächst eine 30 nm dicke Schicht 2 aus Indium aufgedampft. Auf diese Schicht 2 wird dann eine 20 nm dicke Schicht aus Zink 3 aufgebracht. Die erfindungsgemäße 10 nm dicke Schicht 4 aus Chrom-Nickel-Legierung befindet sich auf der Schicht 3. Als oberste Schicht ist die Schicht 5 aus 500 nm Gold vorgesehen, das einen einwandfreien äußeren Kontaktanschluß für einen anzubondenden Draht 6 gewährleistet.

Wie bereits oben erwähnt, wird die Chrom-Nickel-Schicht 4 dadurch hergestellt, daß aus einem Tiegel heraus aufgedampft wird, in dem sich eine Chrom-Nickel-Legierung mit etwa 50% Nickel und etwa 50% Chrom befindet. Die unterschiedlichen Verdampfungseigenschaften führen dazu, daß aus diesem Ausgangsmaterial auf dem Halbleitermaterial bzw. auf der Schicht 3 eine Schicht 4 aus etwa vier Anteilen Chrom und etwa einem Anteil Nickel entsteht, die den erfindungsgemäßen Erfordernissen genügt.

Die voranstehend beschriebenen vier Schichten 2—5 des erfindungsgemäßen Kontakts werden auf dem Halbleitermaterial bzw. zusammen mit dem Halbleitermaterial einer Temperaturbehandlung unterworfen, bei der das bereits erwähnte Einlegieren des Materials der zweiten Schicht in das Halbleitermaterial erfolgt. Diese aus der Schicht 3 durch die Schicht 2 hindurch erfolgende Dotierung des Halbleitermaterials führt zu Kontakten mit spezifischem Kontaktwiderstand $10^{-4}$ und $10^{-5}$ Ohm · cm² bei einer nur geringen Einlegiertiefe von kleiner als 0,2 μm. Für das angegebene spezielle Beispiel empfiehlt sich eine Einlegierungstemperatur von 390°C bei einer Einlegierzeit von 60 sec.

## Patentansprüche

1. Sperrfreier niederohmiger Kontakt für Halbleiterbauelemente in p-leitendem Indium-haltigem III-V-Halbleitermaterial, bestehend aus mehreren Schichten mit einer ersten Schicht auf dem Halbleitermaterial aus Indium, mit einer zweiten Schicht aus einem Kontaktlegierungsstoff mit p-Dotierungswirkung in dem Indiumhaltigen Halbleitermaterial und mit einer obersten, für den äußeren Anschluß zur Verfügung stehenden Metallschicht, wobei die aufeinander aufgebrachten Schichten zum Einlegieren einer gemeinsamen Wärmebehandlung unterworfen worden sind, gekennzeichnet dadurch, daß die Schichtfolge zwischen der zweiten und der obersten (5) Schicht eine dritte (4) Schicht aus Platin, Palladium, Chrom oder einer Chrom-Nickel-Legierung hat.

2. Kontakt nach Anspruch 1, gekennzeichnet dadurch, daß das Indium der ersten Schicht (2) aufgedampft ist.

3. Kontakt nach Anspruch 1 oder 2, gekennzeichnet dadurch, daß die Dicke der Indium-Schicht (2) 20 bis 50 nm beträgt.

4. Kontakt nach Anspruch 1, 2 oder 3, gekennzeichnet dadurch, daß der p-dotierende Stoff der zweiten Schicht (3) Zink, Beryllium oder Kadmium ist.

5. Kontakt nach Anspruch 4, gekennzeichnet dadurch, daß die Dicke der zweiten Schicht (3) 10 bis 30 nm beträgt.

6. Kontakt nach einem der Ansprüche 1 bis 5, gekennzeichnet dadurch, daß das Material der dritten Schicht (4) eine Zusammensetzung mit etwa vier Anteilen Chrom und etwa einem Anteil Nickel aufweist, wie sie sich beim Tiegelverdampfen einer Nickel-50-Chrom-50-Legierung ergibt.

7. Kontakt nach einem der Ansprüche 1 bis 6, gekennzeichnet dadurch, daß die Dicke der dritten Schicht (4) 5 nm bis 20 nm beträgt.

8. Kontakt nach Anspruch 1, gekennzeichnet dadurch, daß auf einem p-leitenden Indium-Gallium-Arsenidphosphid-Halbleitermaterial (1) die erste Schicht (2) aus etwa 30 nm aufgedampftem Indium besteht, die zweite Schicht (3) aus etwa 20 nm Zink besteht, die dritte Schicht (4) aus etwa 10 nm Chrom-Nickel besteht und die vierte Schicht (5) 500 nm aufgedampftes Gold ist.

9. Verfahren zur Herstellung eines Kontakts nach einem der Ansprüche 1 bis 8, gekennzeichnet dadurch, daß eine Einlegierungstemperatur zwischen 350° und 450°C bei einer Zeitdauer von 40 bis 90 s vorgesehen ist.

## Claims

1. A non-rectifying low-resistance contact for semiconductor components in conductive III-V-semiconductor material which contains indium, consisting of a plurality of layers, with a first layer on the semiconductor material, consisting of indium, a second layer consisting of a contact alloy material having a p-doping action in the indium-containing semiconductor material, and a topmost metal layer serving for the outer terminal, wherein the layers, arranged one above another, have been subjected for alloying to a common heat treatment, characterised in that the layer sequence between the second (3) and the topmost layer (5) contains a third layer (4) consisting of platinum, palladium, chromium, or a chromium-nickel alloy.

2. A contact as claimed in Claim 1, characterised in that the indium of the first layer (2) is vapour deposited.

3. A contact as claimed in Claim 1 or 2, characterised in that the thickness of the indium layer (2) is 20 to 50 nm.

4. A contact as claimed in Claim 1, 2 or 3, characterised in that the p-doping material of the second layer (3) is zinc, beryllium, or cadmium.

5. A contact as claimed in Claim 4, characterised in that the thickness of the second layer (3) is 10 to 30 nm.

6. A contact as claimed in one of Claims 1 to 5, characterised in taht the material of the third layer (4) is a compound of approximately four parts chromium and approximately one part nickel, such as is produced in the crucible vaporization of a nickel-50-chromium-50 alloy.

7. A contact as claimed in one of the Claims 1 to 6, characterised in that the thickness of the third layer (4) is 5 nm to 20 nm.

8. A contact as claimed in Claim 1, characterised in that, on a p-conducting, indium-gallium- arsenide-phosphide semiconductor material (1), the first layer (2) consists of about 30 nm vapour deposited indium, the second layer (3) consists of about 20 nm zinc, the third layer (4) consists of about 10 nm chromium-nickel, and the fourth layer (5) is 500 nm vapour-deposited gold.

9. A process for the production of a contact as claimed in one of the Claim 1 to 8, characterised in that an alloying temperature of between 350° and 450° C is used for a period of 40 to 90 s.

## Revendications

1. Contact à basse résistance et sans effet de redressement, pour des composants à semiconducteurs en matériau semiconducteur III-V contenant de l'indium et de conductivité p, constiué de plusieurs couches, avec une première couche sur le matériau semiconducteur en indium, avec une deuxième couche en un matériau d'alliage pour contact ayant un effet de dopage p, dans le matériau semiconducteur contenant de l'indium, et avec une couche métallique qui est la plus élevée et qui est disponible pour le raccordement extérieur, couches déposées les unes sur les autres et étant soumises pour les allier à un traitement thermique commun, caractérisé en ce que la succession de couches entre la deuxième couche (3) et la couche la plus élevée (5) a une troisième couche (4) en palladium, en platine, en chrome ou en alliage de chrome et de nickel.

2. Contact suivant la revendication 1, caractérisé en ce que l'indium de la première couche (2) est déposé par dépôt en phase vapeur.

3. Contact suivant la revendication 1 ou 2, caractérisé en ce que l'épaisseur de la couche d'indium (2) est comprise entre 20 et 50 nm.

4. Contact suivant la revendication 1, 2 ou 3, caractérisé en ce que la substance de dopage p de la deuxième couche (3) est du zinc, du béryllium ou du cadmium.

5. Contact suivant la revendication 4, caractérisé en ce que l'épaisseur de la deuxième couche (3) est comprise entre 10 et 30 nm.

6. Contact suivant l'une des revendications 1 à 5, caractérisé en ce que le matériau de la troisième couche (4) présente une composition comprenant environ quatre parties de chrome et environ une partie de nickel, comme cela résulte d'un dépôt en phase vapeur au creuset, d'un alliage à 50% de nickel et à 50% de chrome.

7. Contact suivant l'une des revendications 1 à 6, caractérisé en ce que l'épaisseur de la troisième couche (4) est comprise entre 5 nm et 20 nm.

8. Contact suivant la revendication 1, caractérisé en ce que sur un matériau semiconducteur (1) d'arséniophosphure d'indium et de gallium de conductivité p, la première couche (2) est constituée d'indium déposé en phase vapeur en une épaisseur de 30 nm environ, la deuxième couche (3) est constituée de zinc en une épaisseur de 20 nm environ, la troisième couche (4) est constituée de chrome-nickel en une épaisseur de 10 nm environ, et la quatrième couche (5) est de l'or déposé en phase vapeur en une épaisseur de 50 nm.

9. Procédé de fabrication d'un contact suivant l'une des revendications 1 à 8, caractérisé en ce qu'il consiste à prévoir une température d'alliage comprise entre 350 et 450° C, pour une durée de 40 à 90 secondes.